Europäisches Patentamt

European Patent Office

Office européen des brevets

(11) Publication number: **0 060 632**
**B1**

(12) **EUROPEAN PATENT SPECIFICATION**

(45) Date of publication of patent specification: 25.09.85

(51) Int. Cl.⁴: **G 11 B 5/37, G 11 B 5/33**

(21) Application number: **82300951.9**

(22) Date of filing: **24.02.82**

(54) **Thin film magneto-resistive sensors and methods for their manufacture.**

(30) Priority: **17.03.81 GB 8108243**

(43) Date of publication of application:
**22.09.82 Bulletin 82/38**

(45) Publication of the grant of the patent:
**25.09.85 Bulletin 85/39**

(84) Designated Contracting States:
**DE FR GB NL**

(56) References cited:
**DE-A-2 358 875**
**DE-A-2 445 988**
**DE-A-2 527 934**
**US-A-3 908 194**

**IBM TECHNICAL DISCLOSURE BULLETIN Vol. 22, No. 5, October 1979, New York R.W. ARNOLD et al. "Wear-resistant substrates for MR heads with good thermal conductivity" pages 2149 to 2150**

(73) Proprietor: **The Secretary of State for Defence in Her Britannic Majesty's Government of The United Kingdom of Great Britain and Northern Ireland Whitehall London SW1A 2HB (GB)**

(72) Inventor: **Jones, Roger Martin**
**13 Parc-y-Fro Road Creigiau**
**Cardiff CF4 8SD Wales (GB)**
Inventor: **Collins, Alan John**
**4 Tyn-y-Cwm Road Pontymister**
**Risca Gwent Wales (GB)**
Inventor: **McQuillin, John Donovan Ranfurly-Knox**
**35A Poolbrook Road**
**Malvern Worcestershire (GB)**

(74) Representative: **Edwards, John Brian et al**
**Procurement Executive Ministry of Defence Patents 1 A (4), Room 2014 Empress State Building Lillie Road London SW6 1TR (GB)**

Courier Press, Leamington Spa, England.

# Description

This invention relates to magneto-resistive thin film magnetic film sensors and to a method for their manufacture.

Such sensors utilise the magneto-resistance effect to detect pulses, or their absence, on magnetic recording medium, e.g. tape or disc. This allows the provision of digital data recording. A pulse or lack of pulse represents a logic one or zero and is built up to form a sequence of logic ones and zeros to provide information in a known manner. Such sensors may also be used to sense information stored in analogue form on the magnetic recording medium.

Magneto-resistive sensing is a convenient and efficient method of retrieving data stored in analogue or digital form on a magnetic recording medium. It is particularly advantageous in terms of its output sensitivity in situations where the relative speed of the sensor with respect to the magnetic medium is either slow or variable when compared to the speed dependent output of a conventional inductive type sensor. The output sensitivity of the sensor is, however dependent upon the successful deposition of the necessary metallic and insulating films upon a suitable substrate material and the selective etching of these films during the fabrication process. The thickness of the magneto-resistive sensing film may be typically 0.03 μm and if deposited directly onto a substrate would necessitate a substrate surface which was smooth and devoid of microscopic irregularities. Such surfaces are normally presented by glass and silicon but in some device designs it is of considerable advantage to be free to choose other substrate materials.

The disadvantage of these other substrate materials may according to the concept of this invention be circumvented by use of a thin layer of photo-resist deposited onto the substrate material and baked hard prior to the deposition of the required metallic and insulating films.

Photo-resist is a light polymerised liquid plastic material for example phenolic resins with sensitisers such as a diazo-compound e.g. diazo-naphthoquinone or diazo-oxide. They can be spun onto substrates in thin layers, etched to a required shape, and hardened by baking. Such baking is more extensive than the usual drying step and serves to make the photo-resist insensitive to light and etchants.

A method of producing a magneto-resistive sensor according to the invention is defined in claim 1.

According to this invention a magneto-resistive sensor comprises a substrate having a surface carrying a layer of photo-resist material hardened by heating, a magneto-resistive element over a part of the photo-resist layer, electrical conductors connected to both ends of the element and a protective coating over the magneto-resistive element. The magneto-resistive element may for example, be rectangular in shape having dimensions of 10 to 50 μm width, .02 to .05 μm thickness and a length up to several time the width.

There are two basic designs of sensor, a vertical sensor and a horizontal sensor.

In a vertical sensor the magneto-resistive element is presented edge on close to the recorded medium or is provided with magnetic cores to provide a close coupling with the recorded medium. Frequently the element is surrounded with magnetic shielding to improve the resolution of the sensor. In this case it is normal practice to deposit by one of a number of techniques a thick layer (several μm) of suitable magnetically permeable material for the base surface of a magnetic shield arrangement. Subsequently the magneto-resistive sensor layers and additional insulating and conducting layers would then be deposited providing selective etching of the individual layers where necessary to produce the required fabrication of the sensor. A further thick layer of suitable shielding material might then be deposited over the whole or part of the sensor to complete the magnetic shield arrangement.

An alternative approach would be to use a substrate material which is also magnetically permeable and suitable for the base layer of a magnetic shield arrangement. Such a material could, for example, be a sintered ferrite. However, the preparation of smooth faultless, ferrite surfaces with no microscopic voids is difficult and might be considered uneconomical of effort in a production sequence for a magneto-resistive sensor.

In this invention the use of a thin hard baked photo-resist layer is introduced to provide a priming layer on the base magnetic shield which is suitable for supporting the thin magneto-resistive layer and any other additional layers which may be required to complete the sensor. This technique avoids extensive preparation of the substrate surface which would otherwise be required.

In the horizontal sensor, the magneto-resistive element is presented to the recorded medium either forward of the substrate material or in the reverse position. In the first mentioned case this will require additional wear resistant layers to be deposited or fixed by adhesion to provide protection of the magneto-resistive sensor element. In the second case the substrate itself will affort the protection but must be thin to avoid excessive loss of sensitivity and also wear resistant. A suitable material for this would be a synthetic sapphire. However the preparation of such a substrate surface poses difficulties owing to the hardness of the substrate and the limited polishing alternatives. In addition the properties of magneto-resistive films deposited directly upon such substrates may be adversely affected by the underlying crystallographic planes as well as by the surface roughness of the substrate.

In this invention a thin photo-resist layer is applied to the substrate surface and baked hard prior to the deposition of the magneto-resistive film. The photo-resist surface provides a stable and smooth surface capable of supporting magneto-resistive films with adequate magnetic properties. The coercivities of films deposited upon baked photoresist has been measured and found to be superior in some instances to otherwise identical films deposited on glass substrates.

Baked photo-resist layers also offer a suitable surface for subsequent depositions of metallic and insulating layers necessary to complete the sensor. In some instances where subsequent layers of films of thicknesses of the order of 1 μm and greater are to be deposited, experimentation has shown that the adhesion of such films to the underlying photo-resist can be improved by the prior deposition of a thin layer (e.g. 0.05 μm) of chromium or other suitable intermediate layer.

Use of photo-resist as a smoothing layer on the substrate and the small size of the component e.g. the element and conductors, allows conventional photo lithographic technique to be employed in constructing the head.

The invention will now be described, by way of example only, with reference to the accompanying drawings in which:—

Figures 1, and 2 are diagrammatic views of vertical and horizontal sensors respectively mounted above a magnetic tape;

Figure 3 shows a vertical sensor mounted closely above a magnetic tape;

Figure 4 is a partly sectioned front view of Figure 3;

Figure 5 is a cross section in the line III—III of Figure 4;

Figure 6 is a cross section of a horizontal sensor mounted above a magnetic recording disc.

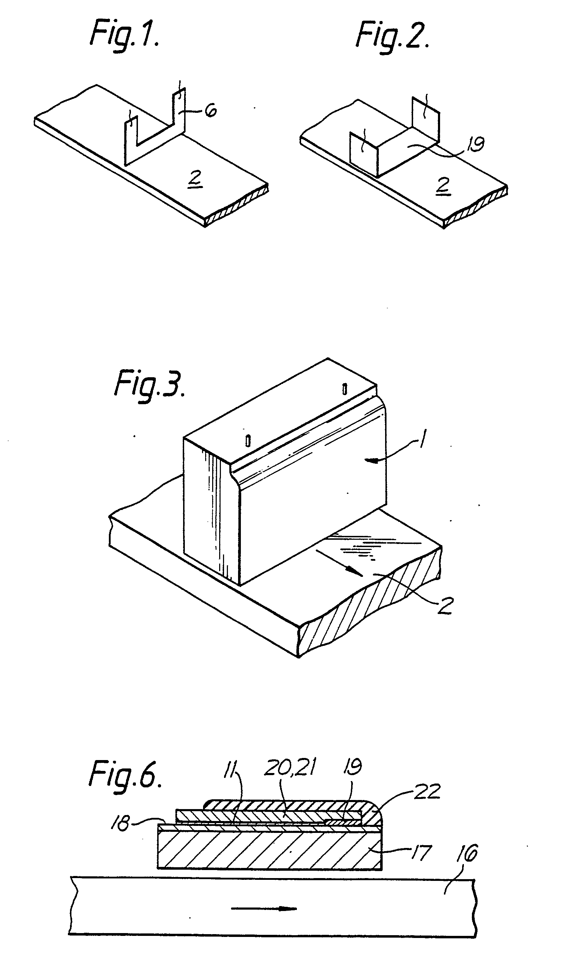

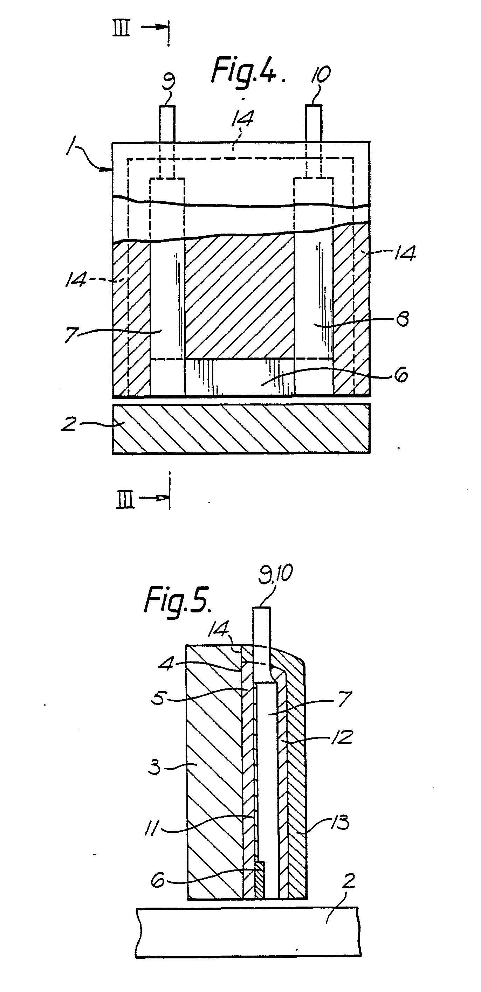

Figures 1, 3, 4 and 5 show a vertical sensor 1 mounted above a magnetic tape 2 that in operation is moved under the sensor 1 by a conventional tape drive system (not shown).

The sensor 1 comprises a ferrite substrate 3 having a flat smooth front surface 4. For example the substrate 3 may be a polycrystalline Ni—Zn ferrite hot isostatically pressed to give good magnetic properties as well as controlled grain size. The pressed ferrite is sliced, lapped and polished by conventional abrasives e.g. silicon carbide and diamond powder to give a flat smooth front surface 4. Unfortunately preparation of this front surface 4 frequently induces microscopic holes.

On the front surface 4 is a layer 5, typically 0.5 to 2 μm thick, of a photo-resist material. A small magneto resistive element 6 of 82% Ni, 18% Fe alloy is formed on the photo-resist layer 5. Typical dimensions are 0.03 to 0.05 μm thick, width 10—50 μm, and of length several times the width.

Gold conductors 7, 8 are formed on the layer and connect both ends of the element 6 via wires 9, 10 to external circuits (not shown). Typically the conductors 7, 8 are greater than 0.1 μm thick. To improve adhesion the conductors 7, 8 may be deposited over a thin e.g. 0.01 μm thick adhesion layer 11 of chromium.

An insulating layer, 12 of photo-resist or other deposited material for example sputtered silicon dioxide is formed over the element 6 and conductors 7, 8 and over this insulating layer 12 a front magnetic shield 13 of, for example, sputtered nickel iron is formed. In some sensors designs additional metallic and insulating layers may be included between the top shield and substrate to provide some means of magnetic bias to the sensor to improve the linearity of the response. In operation the sensor 1 is positioned over a moving tape 2 (or disc) and spaced so that the element 6 is in close proximity to the tape 2. As the tape 2 passes the sensor 1 the change in the magnetic field component perpendicular to the plane of the previously recorded medium is detected by the sensor and the signal thus produced is passed to external circuits.

One example of processing steps for the production of the vertical sensor of Figures 3, 4, 5 is as follows:—

1. The ferrite substrate 3 is placed on the spindle of a photo-resist spinner. A few drops of photo-resist e.g. Shipley AZ 1350H, is placed centrally on the surface 4 of the substrate 3 and allowed to spread outwards. The substrate 3 is then spun at 2,500—5,000 r.p.m. for about 30 seconds to spread the resist evenly over the surface 4. This may be repeated with a second quantity of photo-resist to give a layer 5 of about 1 μm thickness.

2. The layer 5 is dried by baking at 60°C for 15 minutes.

3. Selected areas of the layer 5 are removed by conventional lithography to expose strips 14 of ferrite substrate along the top and both sides of the surface 4 for subsequent deposition of the front shield 13.

4. The layer 5 is baked for about 30 minutes at 180°C to temporarily harden the resist 5 prior to a vacuum baking. The vacuum baking is achieved at a pressure smaller than about $10^{-5}$T for four hours at a temperature of 350°C. Such a baked layer is smooth on a microscopic scale with undulations of wavelengths that are large compared with the thickness of the magneto-resistive element 6.

5. Layers of Ni-Fe 6, Cr 11, and Au 7, 8 are successively deposited on the layer 5 by evaporation or sputtering then selectively removed in reverse order by conventional photolithographic processes. The layer 6 is evaporated onto the resist layer 5 in the presence of a magnetic field aligned parallel to the plane of the film and in a direction related to the final magneto-resistive sensor geometry to provide a known easy axis for the magnetisation.

6. The insulating layer 12 e.g. of photo-resist is deposited and shaped as in steps 1, 2, 3, 4.

7. The front shield 13 of Ni-Fe is sputtered over the layer 12 and onto the exposed strips 14 of substrate 3 so that the element 6 is magnetically shielded around except in the region of the field entry from the recorded medium 2 into the magneto-resistive sensor.

8. The lower surface of the sensor 1 may be ground and polished to the desired profile to expose the element 6.

As shown in Figures 3, 4, 5 only one element 6 is formed in the sensor. Many elements may also be formed side by side along the front face of the substrate 3 and can be arranged to be electrically and magnetically isolated from one another so that a plurality of tracks on a tape or other medium may be sensed simultaneously.

Figure 6 shows a horizontal sensor 15 mounted above a rotatable disc 16. The head 15 comprises a thin sapphire substrate 17 aligned so that its lower surface lies in the 1 1 0 0 crystalline plane (or other hard wearing surface plane). On the substrate 17 is a 1 μm thick layer 18 of photo-resist material which carries a magneto-resistive element 19 and gold connectors 20, 21.

The element 19 is an 82/18 Ni-Fe alloy typically 300Å thick, 10—50 μm wide and length several times its width. An insulating coating 22 of photoresist covers the element 19 and conductors 20, 21. For some applications an upper magnetic shield (not shown) may be provided over the coating. The processing steps are as detailed for the vertical sensor. After deposition of the coating 22 the substrate 17 is ground to its required thickness.

A plurality of elements may be formed on the substrate 17 either side by side across the substrate or in any other desired configuration.

## Claims

1. A method of producing a magneto-resistive sensor comprising the steps of providing a substrate material with a working surface, depositing a thin layer of a photoresist material on the substrate, heating the photoresist material to harden the photoresist and provide a smooth hard surface, depositing a magneto-resistive element on the photo resistive layer, forming electrical connections to the element, forming an insulating layer over the element and conductors.

2. The method of claim 1 wherein the layer of photoresist is obtained by placing a small amount of photoresist onto the substrate and spinning the substrate to spread the photoresist into a thin layer.

3. The method of claim 1 wherein the photoresist is hardened by heating at or above 60°C at atmospheric pressure followed by heating in a vacuum chamber at a pressure below atmospheric pressure.

4. A magneto-resistive sensor comprising a substrate (3, 17) having a surface carrying a thin smooth layer (5, 18), a magneto-resistive element (6, 19) over a part of the thin layer, electrical conductors (7, 8, 20, 21) connected to both ends of the element and a protective coating (12, 22) over the magneto-resistive element (6, 19) characterised in that said thin layer consists of photoresist material hardened by heating.

5. A sensor as claimed in claim 4 wherein the substrate (3) is sintered ferrite.

6. A sensor as claimed in claim 5 wherein the substrate (3) is polycrystalline nickel zinc ferrite.

7. A sensor as claimed in claim 4 wherein the substrate (17) is sapphire.

8. A sensor as claimed in claim 4 wherein the layer (5, 18) of photoresist material is 0.5 to 2 μm thick.

9. A sensor as claimed in claim 4 wherein the magneto-resistive element (6, 19) is formed of a nickel ferrite alloy.

10. A sensor as claimed in claim 4 wherein a thin layer (11) of chrome is deposited on part of the photoresist layer prior to forming the electrical conductors (7, 8, 20, 21).

11. A sensor as claimed in claim 4 wherein the protective coating (12, 22) includes a layer of photo-resist material.

## Revendications

1. Un prodécé de fabrication d'un capteur magnéto-résistif comprenant les phases consistant à former une surface de travail sur un matériau de substrat, à déposer une mince couche d'une matière photo-résistante sur le substrat, à chauffer la matière photo-résistante pour la durcir et réaliser une surface dure lisse, à déposer un élément magnéto-résistif sur la couche photo-résistante, à former des liaisons électriques avec l'élément, et à former une couche isolante sur l'élément et les conducteurs.

2. Le procédé de la revendication 1, dans lequel la couche de matière photo-résistante est obtenue en disposant une petite quantité d'une matière photo-résistante sur le substrat et en faisant tourner le substrat pour étaler la matière photo-résistante en une couche mince.

3. Le procédé de la revendication 1, dans lequel la matière photo-résistante est durcie par chauffage à 60°C ou plus à la pression atmosphérique, suivi d'un chauffage dans une chambre à vide sous une pression inférieure à la pression atmosphérique.

4. Un capteur magnéto-résistif comprenant un substrat (3, 17) ayant une surface portant une mince couche lisse (5, 18), un élément magnéto-résistif (6, 19) sur une partie de la couche mince, des conducteurs électriques (7, 8, 20, 21) reliés aux deux extrémités de l'élément et un revêtement protecteur (12, 22) sur l'élément magnéto-résistif (6, 19), caractérisé en ce que ladite couche mince consiste en une matière photo-résistante durcie par chauffage.

5. Un capteur tel que revendiqué dans la revendication 4, dans lequel le substrat (3) est une ferrite frittée.

6. Un capteur tel que revendiqué dans la revendication 5, dans lequel le substrat (3) est une ferrite nickel-zinc polycristalline.

7. Un capteur tel que revendiqué dans la revendication 4, dans lequel le substrat (17) est du saphir.

8. Un capteur tel que revendiqué dans la revendication 4, dans lequel la couche (5, 18) de matière photo-résistante a une épaisseur de 0,5 à 2 μm.

9. Un capteur tel que revendiqué dans la revendication 4, dans lequel l'élément magnéto-résistif (6, 19) est formé d'un alliage nickel-ferrite.

10. Un capteur tel que revendiqué dans la revendication 4, dans lequel une mince couche (11) de chrome est déposée sur une partie de la couche photo-résistante avant de former les conducteurs électriques (7, 8, 20, 21).

11. Un capteur tel que revendiqué dans la revendication 4, dans lequel le revêtment protecteur (12, 22) comprend une couche d'une matière photo-résistante.

**Patentansprüche**

1. Verfahren zur Herstellung eines magnetoresistiven Fühlers, das die folgenden Schritte umfaßt: Bereitstellen eines Substratmaterials mit einer Arbeitsfläche, Aufbringen einer dünnen Schicht eines lichtempfindlichen Materials auf das Substrat, Erhitzen des lichtempfindlichen Materials zum Härten derselben und zur Herstellung einer glatten harten Oberfläche, Aufbringen eines magnetoresistiven Elements auf die lichtempfindliche Schicht, Herstellen elektrischer Anschlüsse an das Element, Herstellen einer Isolierschicht über dem Element und den Leitern.

2. Verfahren nach Anspruch 1, bei welchem die lichtempfindliche Schicht dur Aufbringen einer kleinen Menge von lichtempfindlichen Material auf das Substrat und schnelles Drehen des Substrats zum Ausbreiten des lichtempfindlichen Materials zu einer dünnen Schicht hergestellt wird.

3. Verfahren nach Anspruch 1, bei welchem das lichtempfindliche Material durch Erhitzen auf oder über 60°C bei Atmosphärendruck und nachfolgendes Erhitzen in einer Vakuumkammer bei einem Druck unter Atmosphärendruck gehärtet wird.

4. Magnetoresistiver Fühler, der ein Substrat (3, 17) mit einer eine dünne Schicht (5, 18) tragenden Oberfläche, ein über einem Teil der dünnen Schicht befindliches magnetoresistives Element (6, 19), an den beiden Enden des Elements angeschlossene elektrische Leiter (7, 8, 20, 21) und einen Schutzüberzug (12, 22) über dem magnetoresistiven Element (6, 19) aufweist, dadurch gekennzeichnet, daß die dünne Schicht aus einem durch Erhitzen gehärteten lichtempfindlichen Material besteht.

5. Fühler nach Anspruch 4, bei welchem das Substrat (3) aus gesintertem Ferrit besteht.

6. Fühler nach Anspruch 5, bei welchem das Substrat (3) aus polykristalinem Nickel-Zink-Ferrit besteht.

7. Fühler nach Anspruch 4, bei welchem das Substrat (17) aus Saphir besteht.

8. Fühler nach Anspruch 4, bei welchem die Schicht (5, 18) aus lichtempfindlichem Material 0,5 bis 2 μm dick ist.

9. Fühler nach Anspruch 4, bei welchem das magnetoresistive Element (6, 19) aus einer Nickel-Ferrit-Legierung gebildet ist.

10. Fühler nach Anspruch 4, bei welchem eine dünne Schicht (11) aus Chrom auf einem Teil der lichtempfindlichen Schicht aufgebracht wird, bevor die elektrischen Leiter (7, 8, 20, 21) gebildet werden.

11. Fühler nach Anspruch 4, bei welchem der Schutzüberzug (12, 22) eine Schicht aus lichtempfindlichem Material aufweist.

# Fig.1.

6

2

# Fig.2.

19

2

# Fig.3.

1

2

# Fig.6.

11  20,21  19  22

18

17  16

Fig.4.

Fig.5.